# EUROPEAN PATENT APPLICATION

(11) **EP 1 601 226 A1**
(43) Date of publication of application: **30.11.2005**
(21) Application number: 04012119.6
(22) Date of filing: 21.05.2004
(51) Int. Cl.: H04R 3/00, H03F 3/26

(54) **High performance audio amplifier**

(71) Applicant: Harman Becker Automotive Systems GmbH, 76307 Karlsbad (DE)
(72) Inventor: Jurzitza, Dieter, Dr., 76131 Karlsruhe (DE)
(74) Representative: Schmuckermaier, Bernhard

(57) **Abstract**

An audio amplifier arrangement for powering a loudspeaker, comprising: a supply voltage; a first terminal for receiving an input signal representing the original input audio signal; a second terminal for receiving the inverted signal of said input signal, said inverted signal representing the inverted of said original input audio signal; a first amplifier for receiving said input signal and, powered by said supply voltage, generating a first current accordingly; a second amplifier for receiving said inverted signal and, powered by said supply voltage, generating a second current accordingly; and a coil arrangement, said coil arrangement being the voice coil of said loudspeaker and having a middle point thereof connected to said supply voltage and two end points thereof connected to said first and second amplifiers for receiving said first and second currents.

## Description

### Field of the invention

This invention relates to audio amplifiers for driving loudspeakers and, in particular, to transistor type amplifiers. The audio amplifier in accordance with this invention produces a high output with just a few components.

### Background of the invention

An audio amplifier, or power amplifier, is an indispensable component of a sound system which uses a loudspeaker to generate sound waves. The amplifier takes the input audio signal, which is generally small, and boosts it up to an output signal that is powerful enough to drive the loudspeaker.

Based on variations in the input audio signal, the output signal causes an alternating current driving the loudspeaker and, in particular, the voice coil of the loudspeaker. The voice coil is an electrical magnet and is positioned in a constant magnetic field created by a permanent magnet of the loudspeaker. These two magnets - the electrical magnet and the permanent magnet - interact with each other by repulsion and attraction. When the electrical current flowing through the voice coil changes direction, the coil's polar orientation reverses and in turn changes the direction of the magnetic forces between the voice coil and the permanent magnet, thus moving the coil and the attached diaphragm thereof back and forth. This movement vibrates the air in front of the loudspeaker, creating sound waves. Traditionally, audio amplifiers for driving such loudspeakers are categorized into classes such as classes A, B, AB, etc.

Class A is the simplest form of amplifiers. The amplifying element(s) in class A amplifiers are biased so that, regardless of the magnitude of the input audio signal, it is never completely on and never completely off. This not-off/not-on area is known as the linear region. This form of amplifier produces output with a very low distortion but is very inefficient for a great deal of current as power is wasted keeping the power element in a linear region.

Class B amplifiers typically involve two active power elements, such as a pair of complementary transistors, each responsible for amplifying one half of the audio wave form. These two active elements are connected in such a way that they can "push-pull" the current: One drives the output while the other sinks it. Therefore, class B amplifiers are more efficient than their class A counterparts. The problem with class B amplifiers, however, lies in the small region where one transistor is just turning off and the other is just turning on. This causes a non-linear condition because a transistor tends to make a small step turning on. Consequently, this non-linear region results in distortion.

Class AB, as its name suggests, is a combination of classes A and B. It employs a mechanism that supplies a small bias to each transistor of a to class B amplifier so that it is never completely off. Thus, compared to class A, there is less wasted power on one hand and, on the other other hand, distortion is much lower as in class B.

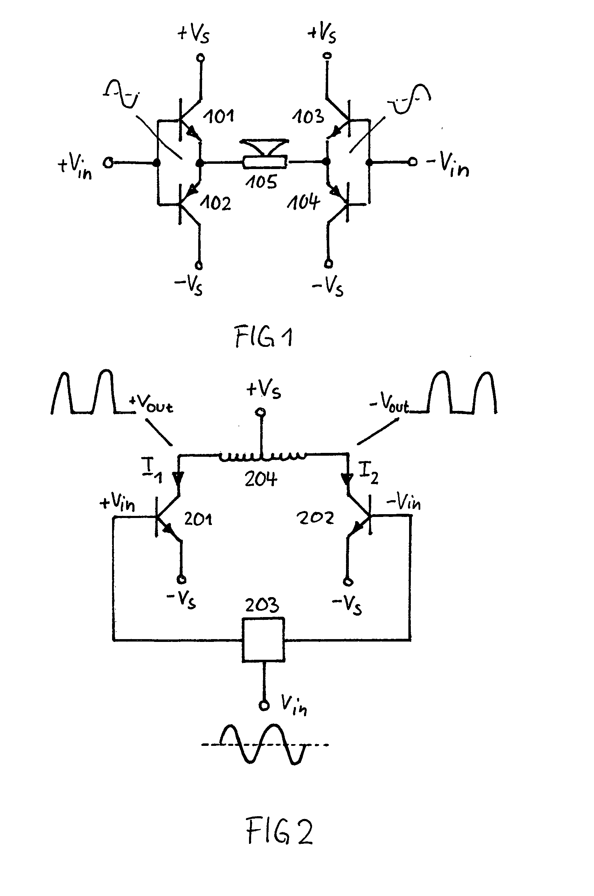

Amplifiers of the bridge amplifier type are usually employed in low-voltage supply situations where a higher voltage output is desired. As depicted in Fig. 1, a typical class B bridge amplifier comprises two identical amplifiers, here two sets of complementary transistors (101 and 102; 103 and 104), supplied by a supply voltage +Vₛ, -Vₛ and driven by the same signal +Vᵢₙ, except that the signal to one of them (M₃ and M₄) is inverted (-Vᵢₙ) so that the output voltage of one amplifier goes up while the output voltage of the other amplifier goes down and vice versa. Connecting the load, such as a loudspeaker 105, between the outputs of the two amplifiers gives double the voltage and four times the power compared to a single amplifier.

One important goal of a good audio amplifier is a high output signal with as little distortion as possible. In conventional implementation, this goal often translates into a large number of components in the amplifier circuitry. An increased number of components often lead to a more complex circuitry which inevitably gives rises to more electromagnetic interference, a higher power loss, and more heat which needs to be dissipated. The heat dissipation in turn calls for a more powerful and often larger cooling devices which increase the amplifier's demand for space. However, many sound systems of today, such as car audio systems, do have strict restrictions on their physical dimension and circuitry complexity. Thus, it is difficult to produce an audio amplifier which meets all the desired objectives.

There have been several approaches to solve these problems, but none of them has been very satisfactory. A conventional approach is the non-integrated bridge final stage. Compared to an integrated power amplifier, this approach usually uses more components and needs therefore more space to be implemented but allows a higher power output.

Another approach is the class D amplifier. A class D amplifier, which may also be known as a switching amplifier, employs pulse width modulation (PWM). A class D amplifier utilizes output transistors which are either completely turned on or completely turned off (they are operating in switch mode). When a transistor is off, the current through it is zero. When it is on, the voltage across it is small, ideally zero. In each case, the power dissipation is very low. This increases the efficiency thus requiring less power from the power supply and small heat sinks for the amplifier's cooling system. Despite these distinctive advantages class D amplifiers suffer from a major drawback, that is, a high demand on the circuitry. The circuitry and signal processing of a class D amplifier is very complex.

Therefore, there is still a need to provide an audio amplifier which generates a high output voltage but using just a smaller number of components. It is, accordingly, an object of this invention to provide a high-output audio amplifier with few components.

### Summary of the invention

This invention presents an audio amplifier arrangement using only two amplifying elements. Preferably, these amplifying elements are transistors, such as FET transistors, bipolar transistors, and the like. One amplifying element has an input terminal to receive a signal representing the original input audio signal while the other amplifying element has an input terminal to receive a signal representing the inverted of the original input signal. Powered by a supply voltage, the two amplifying elements amplify their received signals and generate two voltage (or current) signals according to the negative or positive half wave of the input signal respectively. The amplifying elements are further connected to a specific voice coil arrangement, e. g. a double voice coil or one voice coil having a center tap, for the loudspeaker driven by the generated currents and in turn create sound waves having a power similar to those created by bridge amplifiers.

An audio amplifier arrangement for powering a loudspeaker according to the invention comprises a supply voltage; a first terminal for receiving an input signal representing the original input audio signal; a second terminal for receiving an inverted input signal, said inverted input signal representing the inverted of said original input audio signal; a first amplifier for receiving said input signal and, powered by said supply voltage, generating a first output signal (e.g. current or voltage signal) accordingly; a second amplifier for receiving said inverted signal and, powered by said supply voltage, generating a second output signal (e.g. current or voltage signal) accordingly; and a coil arrangement, said coil arrangement being the voice coil of said loudspeaker and having a middle point thereof connected to said supply voltage and two end points thereof connected to said first and second amplifiers for receiving said first and second output signals.

### Brief description of the drawings

The invention can be better understood with reference to the following drawings and description. The components in the figures are not necessarily to scale, instead each being placed upon illustrating the principles of the invention. Moreover, in the figures, like reference numerals designate corresponding parts. In the drawings:
- FIG. 1: illustrates a typical prior art class B bridge amplifier circuit;
- FIG. 2: is a schematic diagram of an audio amplifier arrangement in accordance with this invention;
- FIG. 3: is a detailed circuit diagram of an audio amplifier arrangement in accordance with this invention; and
- FIG. 4: is a side view of a loudspeaker having amplifying elements attack thereto.

### Detailed description

FIG. 2 is a schematic diagram of the audio amplifier arrangement of this invention and demonstrates the inventive concept thereof. The audio amplifier arrangement of this invention uses two amplifying elements only, 201 and 202. Preferably, these amplifying elements are transistors, such as FET transistors, bipolar transistors, and the like. One amplifying element 201 has an input terminal to receive an input signal +Vᵢₙ representing the original input audio signal Vᵢₙ while the other amplifying element 202 has an input terminal to receive an inverted input signal -Vᵢₙ representing the inverted of the original input signal Vᵢₙ.

The input signal +Vᵢₙ and the inverted input signal -Vᵢₙ are generated in a splitter circuit 203 from the original input signal Vᵢₙ. The splitter circuit 203 splits the original input signal Vᵢₙ into the positive and negative half wave and rectifies the two half waves so that two unipolar 180 degree phase shifted signals forming the input signals +Vᵢₙ and -Vᵢₙ are obtained. Powered by a supply voltage +Vₛ, -Vₛ, the two amplifying elements amplify their received signals and generate two currents I₁ and I₂ accordingly. The amplifying elements are further connected to a voice coil arrangement of a loudspeaker (not shown in FIG. 2), comprising a voice coil 204 with two end points 204a, 204c and a middle point 204b such that one part of the arrangement (204a, 204b) and the other part (204b, 204c)each are supplied with output voltages +Vₒᵤₜ and -Vₒᵤₜ generated from the input signals +Vᵢₙ and -Vᵢₙ by the amplifier elements 201 and 202 so that through each part of the voice coil a current I₁ or I₂ respectively flows and, in turn, effects the wanted sound waves. The output signals +Vₒᵤₜ and -Vₒᵤₜ generated from the input signals +Vᵢₙ and -Vᵢₙ can each have the full swing from the supply voltage -Vₛ to the supply voltage +Vₛ which is twice of a conventional amplifier output.

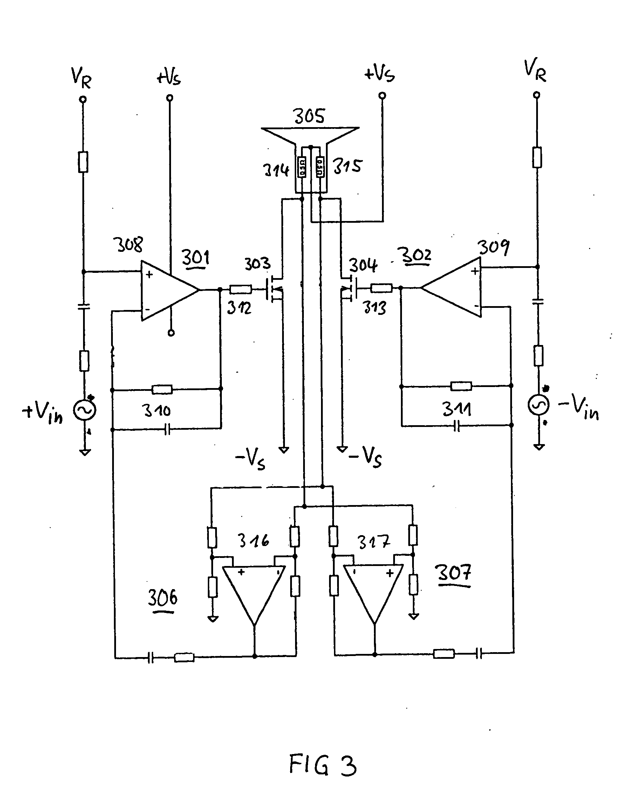

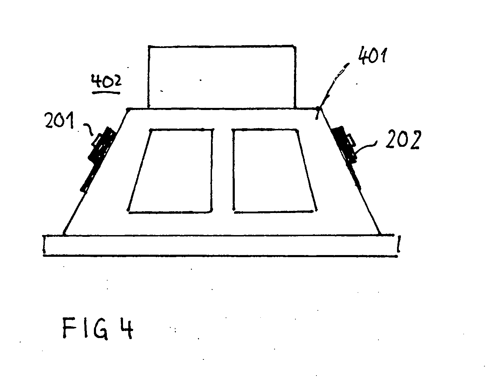

The amplifying elements 201 and 202 are mounted directly on a loudspeaker, for example, on a metal basket 401 (or chassis) of the loudspeaker 402 for cooling the amplifying elements 201 and 202 as shown in FIG. 4. The voice coil arrangement may comprise either a single coil with a center tap (as shown in FIG. 2) or two coils connected together (as shown in FIG. 3). When two coils are used for this coil arrangement, these two coils are identical and their connecting point, called the "middle point" of the coil arrangement, is connected to the supply voltage +Vₛ (or -Vₛ as the case may be) of the two amplifying elements. When one single coil is used for the coil arrangement, the center tap is considered as the "middle point" and is connected to the supply voltage +V_{cc} (or -V_{cc} as the case may be).

Referring to FIG. 3, an audio amplifier arrangement according to the present invention comprises three major circuit blocks: a drive stage, an output (or amplifying) stage, and a feedback stage. The drive stage, identified as 301 and 302 in FIG. 3, is a pre-amplifier stage that receives a non-inverted and inverted input signal +Vᵢₙ, -Vᵢₙ, and outputs a boosted input signal to the output stage. The output stage comprises amplifier elements 303, 304 similar to those discussed in FIG. 2 and outputs amplified input signals as output signals +Vₒᵤₜ, -Vₒᵤₜ to a loudspeaker 305. The feedback stage, labeled 306 and 307, is a differential amplifier stage that interconnects the outputs and the inputs of the two output stages 303, 304 and ensures that the output signal follows the input signals +Vᵢₙ, -Vᵢₙ.

The drive stage which is supplied with the input signals +Vᵢₙ, -Vᵢₙ representing the original input audio signal and the inverted signal thereof, or vice versa, comprises a pair of operational amplifiers 308 and 309 with +Vₛ and -Vₛ as the operating voltage. The non-inverting input of the operational amplifier 308 of stage 301 is supplied with signal +Vᵢₙ and the non-inverting input of the operational amplifier 309 of stage 302 is supplied with -Vᵢₙ. Preferably, these two amplifiers 308 and 309 are biased, by a threshold voltage V_{R}, so as to reduce the non-linear distortion. For frequency compensation reasons, operational amplifiers 308, 309 each comprise an RCelement 310, 311 connected between output and inverting input of the operational amplifiers 52, 53 respectively.

The two operational amplifiers 308, 309 in the drive stages 301, 302 work in the same fashion, that is, receiving the respective input signal and generating a control signal based thereupon. However, as +Vᵢₙ and -Vᵢₙ are inverted, the two amplifiers 308, 309 providing inverse signals. Whenever +Vᵢₙ is positive (-Vᵢₙ is thus negative) the operational amplifier 308 turns output stage 303 on and the other 309 is off; whenever +Vᵢₙ is negative (-Vᵢₙ is thus positive) the operational amplifier 309 is turned off while operational amplifier 308 is on. The voltage signals output from these operational amplifiers 308, 309 are further directed to control the output stages 303, 304. Specifically, the output signal from operational amplifier 308 is led to an input terminal of the output stage 303 through a resist or 312 and that from operational amplifier 309 to an input terminal of the output stage 304 through another resist or 313. It thus can be seen that these two operational amplifiers 308, 309 are pre-amplifiers which boost their respective input signal up to a stronger output signal to power the amplifying elements in the output stages 303, 304. In certain situations, several such pre-amplifier stages can be used to gradually build up a high voltage output signal.

The amplifying elements 303 and 304 are preferably semiconductor devices, such as transistors, for example, MOSFETs. The control electrodes 60 and 61 of the transistors are connected to res respectively, receiving the control voltage signals from the drive stages 301, 302. The source (or drain) electrodes of the transistors are connected to the external endings of a coil arrangement comprising two voice coils 314, 315.

The coil arrangement can either be two identical coils as in FIG. 3 linked together at a point referred to as the "middle point," or one single coil with a center tap serving as the "middle point." This middle point is connected to the supply voltage +Vₛ. The two external endings of this coil arrangement are connected to the transistors, and to be exact, one ending connected to the drain electrode 64 of M₁, the other ending 68 to the source or drain electrode 65 of M₂.

The two amplifying elements and the coil arrangement together function as a bridge amplifier as well as a class B amplifier. The control voltage signals from the drive stage are exerted on the gate electrodes (60 and 61) of M₁ and M₂. These control voltage signals are, in effect, an amplified replica of the original input audio signal and, therefore, whenever the original input signal is positive, the operational amplifier 308 outputs a control voltage signal to the control electrode of amplifying element 303 and thus current starts to flow through amplifying element 303 and further through the voice coil 314 causing a membrane of loudspeaker 303 to vibrate; and whenever the original input audio signal is negative, the operational amplifier 304 is turned on and outputs a control voltage signal to the control electrode of amplifying element 304 and, similarly, current starts to flow through the voice coil 315 causing the membrane to vibrate in opposite direction. In short, the amplifying elements 303, 304 and the coil arrangement cooperate to generate a current driving the voice coils 314, 315 from two sides, similar to a bridge amplifier, and each amplifying element 303, 304 amplifying one half of the audio wave form, as does a class B amplifier.

Although the above drive and output stages alone can accomplish the desired amplification task, it is usually preferred to include a feedback stage into the amplifier arrangement to improve the overall performance. As shown in FIG. 3, a negative feedback circuitry is implemented with differential amplifier stages 306 and 307. The end points of said coil arrangement are connected to the inputs of two differential amplifiers 316 and 317. The differential amplifiers 316, 317 measure the voltage across the amplifying elements 303 and 304 and generate differential signals accordingly. These deferential signals are fed back to the drive stages 301 and 302. In the case where the amplifying arrangement comprises the pre-amplifying stage as described before, the differential signals are fed back to two pre-amplifiers. This negative feedback ensures that the wave form of the signal output to the loudspeaker is in accordance with the original input audio signal.

The audio amplifier arrangement of this invention can be positioned directly on the loudspeaker similar as shown in FIG. 4. For instance, the amplifying elements, here transistors 303 and 304, can be attached to the metal basket of the loudspeaker. This positioning brings several benefits. For example, since the amplifier arrangement is mounted directly on the loudspeaker, one can avoid using a thick line, as required in conventional amplifiers, to connect the amplifier with the loudspeaker, thus significantly reducing the thermal load and the space requirement of the control device, such as a car radio, of the audio system. Further, due to the vicinity of the amplifying transistors to the loudspeaker, the air flow generated by the vibration of the loudspeaker diaphragm can be directly used as a cooling means to dissipate the heat produced by the transistors.

The amplifying elements are mounted directly on the loudspeaker, for example, on the sheet metal of the loudspeaker. In the case where the power elements are transistors, the gate electrode of one transistor receives either the original audio input signal, or an amplified replica thereof, and the gate electrode of the other transistor receives either the inverse of the original audio input signal, or an amplified inverse thereof. These two transistors have their output electrodes directly connected to the voice coil of the loudspeaker. The voice coil comprises either two coils connected together or one single coil with a center tap.

When two coils are used for this coil arrangement, these two coils are identical and their connecting point, called the "middle point" of the coil arrangement, is connected to the supply voltage of the two transistors 303 and 304; when one single coil is used for the coil arrangement, the center tap is considered as the "middle point" and is connected to the power supply. In both cases, the external endings of the coil arrangement are connected to the output electrodes of the transistors. To be exact, one of the two external endings is connected to the output electrode of one transistor while the other ending to the output electrode of the other transistor. The two transistors are mounted directly on the loudspeaker, for example, on the metal basket of the loudspeaker.

From one point of view, the audio amplifier arrangement of this invention works like a bridge amplifier because the two amplifying elements thereof drive a common load, the loudspeaker, from two sides. From another point of view, this audio amplifier arrangement is a class B type, with each amplifying element amplifying one half of the audio wave form.

The audio amplifier arrangement of this invention has numerous advantages, the first and foremost being a reduced number of elements. While achieving the same effect as the conventional class B bridge amplifier as shown in Fig. 3, the amplifier arrangement of this invention is much simpler because it cuts down the number of output transistors from four to two. By minimizing the number of amplifying elements, this amplifier arrangement lowers the demand for power thus it can work under conditions where the power supply can be either high or low, reduces the power loss and in turn the demand for a large cooling device, simplifies the drive stage needed for the amplifying elements so that the complexity of the overall circuitry and the demand for space are minimized. Next, since this amplifier arrangement can be mounted directly on the loudspeaker, one can avoid using a thick line to connect the amplifier with the loudspeaker, as is required in conventional amplifiers, thus significantly decreasing the thermal load and the space requirement of the control device of the audio system. Last but not least, the mounting of the amplifying elements on the loudspeaker additionally assists with the heat dissipation as the air flow generated by the movement of the diaphragm can be used to dissipate the heat produced by the amplifying elements.

This amplifier arrangement can be extended to include preamplifier stages, feedback circuits, and so on, to further increase the output and/or improve the sound quality. When the load is too much work for the original audio signal, one or more pre-amplifier stages can be used to output a strong voltage signal (according to the original input audio signal) to control the two amplifying elements. This control signal can be as high as closed to the operating voltage of the preamplifier. Negative feedback loops can be implemented with differential amplifier stages, whose input signals can be the differential signals between the source and drain electrodes of the transistors.

Although the preferred embodiment of this invention has been described herein above in detail, it is desired to emphasize that this has being for the purpose of illustrating the invention and should not be considered as necessarily limitative of the invention, it being understood that many modifications and variations can be made by those skilled in the art while still practicing the invention claimed herein.

## Claims

1. An audio amplifier arrangement for powering a loudspeaker, comprising:
a supply voltage;
a first terminal for receiving an input signal representing the original input audio signal;
a second terminal for receiving the inverted signal of said input signal, said inverted signal representing the inverted of said original input audio signal;
a first amplifier for receiving said input signal and, powered by said supply voltage, generating a first current accordingly;
a second amplifier for receiving said inverted signal and, powered by said supply voltage, generating a second current accordingly; and
a coil arrangement, said coil arrangement being the voice coil of said loudspeaker and having a middle point thereof connected to said supply voltage and two end points thereof connected to said first and second amplifiers for receiving said first and second currents.

2. The audio amplifier arrangement of claim 1 wherein said coil arrangement comprises one coil with a center tap, said center tap being said middle point of said coil arrangement and the two external endings of said one coil being said two end points of said coil arrangement.

3. The audio amplifier arrangement of claim 1 wherein said coil arrangement comprises two identical coils connected together with the connecting point forming said middle point of said coil arrangement, and the two external endings of said two identical coils being said two end points of said coil arrangement.

4. The audio amplifier arrangement of one of the preceding claims wherein said first amplifier is a first transistor and said second amplifier is a second transistor.

5. The audio amplifier arrangement of claim 4 wherein said first and second transistors are FET transistors.

6. The audio amplifier arrangement of claim 4 wherein said first and second transistors are bipolar transistors.

7. The audio amplifier arrangement of one of claims 4 to 6 wherein said first and second transistors have their output electrodes connected to said two end points of said coil arrangement.

8. The audio amplifier arrangement of one of the preceding claims wherein said first and second amplifiers are mounted directly on said loudspeaker.

9. The audio amplifier arrangement of claim 9 wherein at least one of said first and second amplifiers are mounted on the metal chassis of said loudspeaker.

10. The audio amplifier arrangement of one of the preceding claims further comprising a pre-amplifier stage, said pre-amplifier stage comprising:
supply voltage;
a third terminal for receiving said original input audio signal;
a fourth terminal for receiving the inverted signal of said original input audio signal;
a first pre-amplifier receiving said original audio input signal and connected to said first terminal and outputting a first control voltage signal in accordance with said original input audio signal;
a second pre-amplifier receiving said inverted signal of said original audio input signal and connected to said second terminal and outputting a second control voltage signal in accordance with said inverted signal of said original input audio signal.

11. The audio amplifier arrangement of claim 10 wherein said first and second pre-amplifiers are biased.

12. The audio amplifier arrangement of one of claims 1 to 9, further comprising a negative feedback circuitry comprising differential amplifier stages for generating and outputting differential signals, said differential signals fed back to be mixed with said input signal and said inverted of said input signal and ensure that the wave form of said currents output to said coil arrangement is in accordance with the original input audio signal.

13. The audio amplifier arrangement of claim 12, wherein said differential amplifier stage comprises two differential amplifiers, wherein said end points of said coil arrangement are connected to the inputs of said two differential amplifiers.

14. The audio amplifier arrangement of claim 13, wherein said first and second amplifiers are transistors, wherein said two differential amplifiers measure the voltage across the output electrodes of said transistors and generate said differential signals accordingly.

15. The audio amplifier arrangement of claim 14, wherein said amplifier arrangement comprises the pre-amplifier stage of claim 10, wherein said differential signals are fed back to said two pre-amplifiers.
